# EUROPÄISCHE PATENTSCHRIFT

(11) **EP 3 251 145 B1**
(45) Veröffentlichungstag und Bekanntmachung des Hinweises auf die Patenterteilung: **29.06.2022**
(21) Anmeldenummer: 16703427.1
(22) Anmeldetag: 20.01.2016
(51) Int. Cl.: H01J 37/34, C23C 14/34, C22C 1/05, C22C 32/00, B22F 3/12, B22F 7/06, C23C 14/32, B22F 3/14, H01J 37/32

(54) **VERFAHREN ZUR HERSTELLUNG EINER BESCHICHTUNGSQUELLE UND BESCHICHTUNGSQUELLE**
METHOD OF PRODUCING A COATING SOURCE AND COATING SOURCE
PROCÉDÉ DE FABRICATION D'UNE SOURCE DE REVÊTEMENT ET SOURCE DE REVÊTEMENT

(30) Priorität: 26.01.2015 AT 172015 U
(43) Veröffentlichungstag der Anmeldung: 06.12.2017
(73) Patentinhaber: PLANSEE COMPOSITE MATERIALS GMBH, DE-86983 Lechbruck am See (DE)
(72) Erfinder: POLCIK, Peter, 6600 Reutte (AT); WÖRLE, Sabine, 6600 Pflach (AT)
(74) Vertreter: Ciesla, Bettina
(86) Internationale Anmeldenummer: PCT/EP2016/000092
(87) Internationale Veröffentlichungsnummer: WO 2016/120002

(56) Entgegenhaltungen:
- WO-A1-02/40735
- US-A1- 2005 258 033
- US-A1- 2012 228 131
- US-B1- 6 183 686

## Beschreibung

Die Erfindung betrifft ein Verfahren zur Herstellung einer Beschichtungsquelle zur physikalischen Gasphasenabscheidung mit den Merkmalen des Oberbegriffs von Anspruch 1 sowie eine Beschichtungsquelle zur physikalischen Gasphasenabscheidung mit den Merkmalen des Oberbegriffs von Anspruch 9.

Bei der physikalischen Gasphasenabscheidung (engl. Physical Vapor Deposition, PVD) wird über physikalische Verfahren Ausgangsmaterial in die Dampfphase übergeführt und anschließend auf einem zu beschichtenden Substrat abgeschieden. So werden bei der Kathodenzerstäubung (engl. Sputtering) durch Beschuss einer Oberfläche eines Festkörpers (dem Sputtertarget) mit energiereichen Ionen Atome aus der Oberfläche des Sputtertargets herausgelöst. Das so zerstäubte Material schlägt sich - zusammen mit gegebenenfalls anwesenden zusätzlichen Elementen - auf einem Substrat nieder. Beim Arc-Verfahren wird durch Vakuumbogenentladung Kathodenmaterial verdampft und schlägt sich am Substrat nieder.

Im Kontext der vorliegenden Offenbarung sind unter dem Begriff Beschichtungsquelle (im Folgenden kurz Target genannt) Sputtertargets und Arc-Kathoden zu verstehen.

Im Betrieb sind Targets hohen thermischen Lasten ausgesetzt. Die Leistungsdichten betragen typischerweise ca. 10 W/cm². Zur Vermeidung von Überhitzung des Targets muss die Wärme an eine Wärmesenke, beispielsweise an einen Kühlkreislauf weitergegeben werden. Durch die Beaufschlagung des Targets mit einem Kühlmittel wird das Target auch mechanisch belastet.

Falls das Target selbst keine ausreichende Wärmeleitfähigkeit und/oder keine ausreichende mechanische Festigkeit aufweist, ist es bekannt, den den Beschichtungswerkstoff bildenden Körper mit einem besser wärmeleitenden und/oder mechanisch stabileren Körper zu verbinden. In diesem Fall wird die gesamte Anordnung aus Beschichtungswerkstoff und zusätzlichem Körper als Target bezeichnet.

Aus dem Stand der Technik sind mehrere Verfahren zum Verbinden des den Beschichtungswerkstoff bildenden Körpers mit einem zusätzlichen Körper bekannt.

So zeigt die WO 00/22185 beispielsweise ein Verfahren, worin die Rückseite des Beschichtungswerkstoffes mit der Vorderseite einer als zusätzlicher Körper fungierenden Rückplatte über Diffusionsbonden verbunden wird. Der Beschichtungswerkstoff und die Rückplatte liegen vor dem Diffusionsbonden bereits als plattenförmige Körper vor. Bei diesem Prozess kommt es zur Ausbildung einer scharfen Grenzfläche zwischen dem Beschichtungswerkstoff und der Rückplatte. Im Zuge einer metallografischen Untersuchung erkennt man eine scharf ausgebildete Grenze zwischen Beschichtungswerkstoff und Rückplatte, welche z. B. durch unterschiedliche Texturen des Beschichtungswerkstoffes und der Rückplatte entstehen. Bei mechanischer Beaufschlagung des Targets entstehen Scherspannungen, die zu einem mechanischen Versagen entlang der scharf ausgebildeten Grenzfläche führen können.

Die US 2012/228131 A1 beschreibt ein Vakuum-Heißpress-Verfahren zum Herstellen einer Sputtertargetbaugruppe aus Pulver, wobei das Pulver auf eine Stützplatte durch Diffusionsverbinden des Pulvers mit der Stützplatte verbunden wird. Auch hier liegt eine scharf definierte Grenzschicht vor, mit den oben beschriebenen Nachteilen.

Die US 2005/258033 A1 beschreibt die Herstellung eines mit Silizium infiltrierten Siliziumkarbidtargets durch Heißpressen.

Aus der US 5,397,050 ist ein Verfahren bekannt, wonach eine als fester Körper vorliegende Rückplatte mit einer Pulvermischung, welche den Beschichtungswerkstoff bildet, über heiß-isostatisches Pressen (HIP) verbunden wird. Auch hier liegt eine scharf definierte Grenzschicht vor, mit den oben beschriebenen Nachteilen.

Aus der US 5,282,943 ist ein Verfahren bekannt, wonach eine Beschichtungsquelle zunächst mit einer Mittlerschicht aus Aluminium beschichtet und danach mit der Rückplatte über Löten verbunden wird. Durch das Löten ergibt sich eine Phase mit einem niedrigeren Schmelzpunkt als die Schmelzpunkte der restlichen Phasen des Targets, wodurch die thermische Belastbarkeit des Targets vermindert wird.

Die WO 02/40735 der Anmelderin offenbart ein Verfahren zur Herstellung einer Beschichtungsquelle, bestehend aus einer Targetschicht, die neben einer oder mehreren weiteren Komponenten eine Aluminiumkomponente enthält und einer mit der Targetschicht verbundenen Rückplatte aus einem Werkstoff besserer thermischer Leitfähigkeit als die Targetschicht, wobei das Target durch Kaltpressen einer Mischung der pulverförmigen Einzelkomponenten und anschließendes Umformen hergestellt wird, wobei die Rückplatte ebenfalls aus pulverförmigen Ausgangsmaterial gemeinsam mit den Targetkomponenten in übereinander geschichteten Pulverfraktionen verpresst und anschließend umgeformt wird. Dieses Verfahren ist auf Targetschichten bestehend aus Werkstoffen mit Schmelzpunkten von weniger als 1000 °C, wie z. B. Aluminium, beschränkt. Nur dadurch ergeben sich niedrige Streckgrenzen, was erst eine Verdichtung über Kaltpressen und Umformen durch Schmieden gestattet. Anwendungen bei Targetschichten bestehend aus Werkstoffen mit Schmelzpunkten über 1000 °C sind nicht möglich, was insbesondere die Verarbeitung spröder Werkstoffe wie siliziumreiche Titan-Verbundwerkstoffe unmöglich macht.

Das nicht vorveröffentlichte, prioritätsältere österreichische Gebrauchsmuster AT GM 276/2014 der Anmelderin beschreibt ein Verfahren zur Herstellung einer Beschichtungsquelle zur physikalischen Gasphasenabscheidung, wobei auf eine Targetschicht aus einem metallischen Verbundwerkstoff eine mechanische Stabilisierungsschicht mit besonders hoher Wärmeleitfähigkeit aus Kupfer oder Aluminium über ein hochkinetisches Spritzverfahren aufgebracht wird. Es kommt nicht zu einer Ausbildung einer räumlich ausgebildeten Fügezone sondern es bildet sich aufgrund der unterschiedlichen Texturen der Targetschicht und der mechanischen Stabilisierungsschicht eine Grenzfläche aus, die durchaus uneben ausgebildet sein kann.

Aufgabe der vorliegenden Erfindung ist es, ein gegenüber dem Stand der Technik verbessertes Verfahren zur Herstellung einer Beschichtungsquelle zur physikalischen Gasphasenabscheidung bzw. eine solche Beschichtungsquelle anzugeben.

Gelöst werden diese Aufgaben durch ein Verfahren mit den Merkmalen von Anspruch 1 sowie durch eine Beschichtungsquelle mit den Merkmalen des Anspruchs 9. Vorteilhafte Ausführungsformen der Erfindung sind in den abhängigen Ansprüchen definiert.

Gemäß der Erfindung werden also eine erste Pulvermischung, die in ihrer Zusammensetzung dem wenigstens zweiphasigen Verbundwerkstoff entspricht und eine zweite Pulvermischung, die in ihrer Zusammensetzung der mechanischen Stabilisierungsschicht entspricht, in übereinander angeordneten Schichten durch Heißpressen heiß verdichtet.

Heiß verdichtet bedeutet, dass die Pulvermischungen einem thermisch unterstützten Verdichtungsschritt unterzogen werden. Die thermische Unterstützung dient zur Förderung der zur Verdichtung führenden Kriech- und Sintervorgänge. Die thermische Unterstützung fördert auch plastische Verformung der Pulver während der Verdichtung.

Unter Heißpressen (engl. *hot pressing*) wird in der vorliegenden Offenbarung ein axialer mechanischer Verdichtungsprozess verstanden, bei welchem ein Pulver in einem Presswerkzeug bei solchen Temperaturen axial verdichtet wird, dass ein Sintern des Pulvers zu einem Festkörper erfolgt. Axial bedeutet, dass die Krafteinleitung im Kontrast zu einer isostatischen Verpressung entlang nur einer Raumrichtung erfolgt.

Heißpressen findet typischerweise bei mindestens 40 % der homologen Temperatur (Verhältnis der herrschenden Temperatur / Schmelztemperatur in Kelvin) statt. Die für das Sintern erforderliche Wärme kann indirekt über eine Heizung des Presswerkzeuges und/oder direkt in das Pulver (z. B. durch Strombeaufschlagung und/oder induktive Heizung) eingebracht werden.

Die erste und/oder die zweite Pulvermischung muss nicht zwingend als Pulverschüttung vorliegen. Denkbar ist, dass die erste und/oder zweite Pulvermischung in Form eines nur vorverdichteten Vorpresslings verwendet wird, wobei die Endverdichtung und Verbindung durch das heiße Verdichten erfolgt. Dies kann in verschiedenen Varianten geschehen:
- zwei Pulvermischungen werden jeweils zu einzelnen Vorpresslingen verpresst und dann heiß verdichtet
- nur eine der Pulvermischungen wird zu einem Vorpressling verpresst und dieser anschließend mit der zweiten Pulvermischung heiß verdichtet
- die erste und zweite Pulvermischung werden zu einem Vorpressling verpresst und anschließend heiß verdichtet (ggfs. noch mit weiteren Pulvermischungen)

Die erste Pulvermischung ist bevorzugt homogen ausgebildet. Die zweite Pulvermischung kann homogen oder gradiert ausgebildet sein. Bei einer gradierten Ausbildung ergibt sich ein besonders vorteilhafter Übergang in thermischer und mechanischer Hinsicht zwischen der Targetschicht und der mechanischen Stabilisierungsschicht. Ist eine gradierte Ausbildung vorgesehen, kann diese ihrerseits kontinuierlich oder in Schichten vorliegen.

Die Kontaktierung der Targetschicht und der mechanischen Stabilisierungsschicht erfolgt bevorzugt vollflächig, d.h. über den gesamten Querschnitt. Es ist aber auch vorstellbar, dass etwa die mechanische Stabilisierungsschicht in Form von Rippen oder eines Rasters an der Targetschicht ausgebildet ist. Dazu wird das Presswerkzeug entsprechend gestaltet.

Auch können in die Stabilisierungsschicht zusätzliche verstärkende Strukturen, gegebenenfalls aus unterschiedlichen Werkstoffen, eingebracht werden. Beispielsweise können in die eingestrichene Pulvermischung der späteren Stabilisierungsschicht Drähte, Stäbe oder Gitter eingelegt werden.

Das erfindungsgemäße Herstellungsverfahren weist eine Reihe von Vorteilen auf:
- Es wird eine scharf definierte Grenzfläche zwischen der Targetschicht und der mechanischen Stabilisierungsschicht vermieden, sodass die in Bezug auf den Stand der Technik beschriebenen Nachteile einer solchen Grenzfläche nicht auftreten. Durch das erfindungsgemäße Verfahren ergibt sich vielmehr keine Grenzfläche, sondern eine räumlich ausgedehnte Fügezone, welche ausgehend von der mechanischen Stabilisierungsschicht in einer Richtung zur Targetschicht hin ohne Ausbildung einer scharfen Grenzfläche eine zunehmende Konzentration von Partikeln der weiteren Phase des wenigstens zweiphasigen Verbundwerkstoffes aufweist.
- In Bezug auf das eingangs beschriebene Löten (wie in der US 5,282,943 beschrieben) gibt es keine thermische Schwächung durch das niedrigschmelzende Lötmaterial der Beschichtungsquelle, sodass eine erfindungsgemäß hergestellte Beschichtungsquelle bei viel höheren Leistungen im PVD-Betrieb eingesetzt werden kann.
- Das erfindungsgemäße Verfahren ermöglicht den Einsatz von spröden Werkstoffen für die Targetschicht, für welche ein Verfahren gemäß der WO 02/40735 nicht einsetzbar wäre.

Vorteilhafte Ausführungen beim Heißpressender übereinander angeordneten Schichten der ersten und zweiten Pulvermischung sehen das Einbeziehen von Spark-Plasma-Sintern (SPS) und die Field-Assisted-Sintering-Technology (FAST) vor. Jeweils kann vorgesehen sein, dass die übereinander angeordneten Schichten während des Verpressens mit einem elektrischen Strom beaufschlagt und/oder induktiv geheizt werden.

Beispiele für Werkstoffe, die sich für die erste Pulvermischung bzw. für die Targetschicht eignen, sind titanbasierte Verbundwerkstoffe oder kubisch-raumzentrierte Werkstoffe mit einem spröd-duktil Übergang, wie z. B. chrombasierte, molybdänbasierte, niobbasierte, tantalbasierte oder wolframbasierte Verbundwerkstoffe.

Beispiele für Werkstoffe, die sich für die zweite Pulvermischung bzw. für die mechanische Stabilisierungsschicht eignen, sind
- reine Metalle wie Titan, Eisen, Nickel, Kupfer
- Legierungen der oben genannten reinen Metalle
- Verbundwerkstoffe auf Basis der oben genannten reinen Metalle oder der oben genannten Legierungen

Der die Targetschicht bildende wenigstens zweiphasige Verbundwerkstoff enthält eine metallische Phase und wenigstens eine weitere Phase. Die metallische Phase kann in Form einer metallischen Matrix ausgebildet sein, in welche die weitere Phase, etwa in Form von Partikeln, eingebettet ist (Matrix = umhüllende oder kontinuierliche Phase). Dabei sei bemerkt, dass der Volumenanteil einer solchen Matrix durchaus auch unter 50% betragen kann. Die weitere Phase kann von einer metallischen, intermetallischen oder keramischen Phase gebildet sein.

Bevorzugt ist vorgesehen, dass der Werkstoff für die metallische Phase des wenigstens zweiphasigen Verbundwerkstoffes und der Werkstoff der mechanischen Stabilisierungsschicht zu mindestens 80 at.-% aus dem gleichen Metall bestehen. Beispielsweise können die metallische Phase des wenigstens zweiphasigen Verbundwerkstoffes und die mechanische Stabilisierungsschicht aus der gleichen Legierung gebildet sein.

Auch kann vorgesehen sein, dass für die metallische Phase des wenigstens zweiphasigen Verbundwerkstoffes und für die mechanische Stabilisierungsschicht derselbe Werkstoff - ggf. mit geringfügiger Zugabe von Legierungselementen und/oder in unterschiedlicher Reinheit - verwendet wird.

Ebenfalls vorstellbar ist, dass die metallische Phase des wenigstens zweiphasigen Verbundwerkstoffes und die mechanische Stabilisierungsschicht aus dem gleichen metallischen Werkstoff bestehen.

Dadurch wird ein besonders vorteilhafter Übergang in thermischer und mechanischer Hinsicht zwischen der Targetschicht und der mechanischen Stabilisierungsschicht erreicht. Für die mechanische Stabilisierungsschicht kann gegebenenfalls Pulver geringerer Reinheit verwendet werden, als es für die Targetschicht erforderlich ist. Auch können legierte Pulver verwendet werden, um z.B. die Festigkeit der Stabilisierungsschicht zu erhöhen.

Es kann vorgesehen sein, dass in die mechanische Stabilisierungsschicht ebenfalls Partikel der weiteren Phase eingebettet sind. Dies kann beispielsweise zur Anpassung von physikalischen und / oder mechanischen Eigenschaften der Stabilisierungsschicht an die Targetschicht vorteilhaft sein. Somit kann vorgesehen sein, dass die mechanische Stabilisierungsschicht ihrerseits aus einem wenigstens zweiphasigen Verbundwerkstoff besteht.

### Herstellungsbeispiel 1:

Zur Herstellung einer Titan-Silizium-haltigen Beschichtungsquelle mit einer Stabilisierungsschicht aus Titan wird wie folgt vorgegangen.
- Mischen von Titan (Ti) und TiSi₂ (Titandisilizid) Pulver zu einem Titan-Silizium (TiSi)-Ansatz als erste Pulvermischung
- Füllen eines Presswerkzeuges (hier ein Graphit-SPS Werkzeug) mit reinem Titan-Pulver als zweite Pulvermischung
- Füllen des bereits halb gefüllten Werkzeuges mit dem TiSi-Ansatz
- Verdichten der zweischichtigen Aufbaus durch SPS im Temperaturbereich von 900-1400°C
- Mechanisches Endbearbeiten zu Targets durch Zerspanung

Die Bezeichnung "TiSi-Ansatz" für einen Ansatz aus Titan- und Siliziumhaltigen Spezies bedeutet nicht, dass Titan und Silizium in einem molaren Verhältnis von 1:1 eingebracht werden. In anderen Worten, ist "TiSi" hier nicht als chemische Formel zu verstehen.

Das resultierende Target weist folgende Eigenschaften auf:
- Zweischichtiger Aufbau aus einer spröden TiSi-Targetschicht und einer duktilen Rückplatte aus Titan als mechanische Stabilisierungsschicht
- Das Verhältnis der thermischen Ausdehnungskoeffizienten des die Targetschicht bildenden Verbundwerkstoffs und der Stabilisierungsschicht liegt zwischen 0,5 und 2,0, bevorzugt zwischen 0,75 und 1,33.
- Der Übergang von Targetschicht zur Stabilisierungsschicht ist kontinuierlich unter Ausbildung einer Fügezone jedoch ohne Ausbildung einer Grenzfläche, wie es bei Diffusionsbonden oder Löten auftritt

Weitere Vorteile und Einzelheiten der Erfindung werden anhand der Figuren diskutiert.

Dabei zeigen:
- Fig. 1: einen metallografischen Schliff ,
- Fig. 2a und Fig. 2b: einen weiteren metallografischen Schliff mit einer Korngrenzenätzung
- Fig. 3: eine Beschichtungsquelle (Target)
- Fig. 4: ein Presswerkzeug.

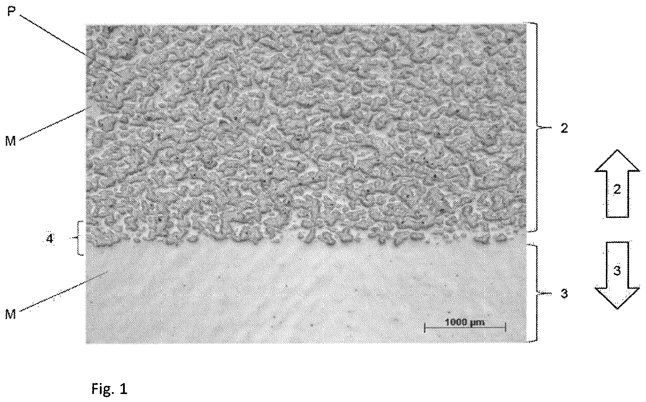

Figur 1 zeigt einen metallografischen Schliff einer Fügezone 4 einer erfindungsgemäßen Beschichtungsquelle 1, durch welche eine Targetschicht 2 (in diesem Fall TiSi 70/30 at%) und eine mechanische Stabilisierungsschicht 3 (in diesem Fall Titan) verbunden sind.

Die Figur zeigt natürlich nur Ausschnitte der Targetschicht 2, der Fügezone 4 und der Stabilisierungsschicht 3. Die Pfeile am rechten Bildrand geben die Orientierung des gezeigten Bildausschnittes an. Der Pfeil mit Bezugszeichen 2 weist in die Richtung, in welche sich die Targetschicht 2 erstreckt. Der Pfeil mit Bezugszeichen 3 weist in die Richtung, in welche sich die Stabilisierungsschicht 3 erstreckt.

Die Breiten der die jeweiligen Schichten kennzeichnenden Klammern müssen nicht den realen Schichtstärken entsprechen, sondern dienen zur Identifikation der jeweiligen Schichten.

Gut erkennbar ist die in die metallische Phase M als erste Phase der Targetschicht 2 eingebettete weitere Phase P des wenigstens zweiphasigen Verbundwerkstoffes. Die metallische Phase M bildet hier also die Matrix. Im gezeigten Ausführungsbeispiel entspricht die Phase M der Targetschicht 2 der Stabilisierungsschicht 3. In anderen Worten besteht die mechanische Stabilisierungsschicht 3 aus dem gleichen Material, welches die Phase M der Targetschicht 2 bildet.

Die weitere Phase P im vorliegenden Ausführungsbeispiel ist ein Titan-Silizid und ist in eine von der metallischen Phase M gebildete Matrix aus Titan eingebettet.

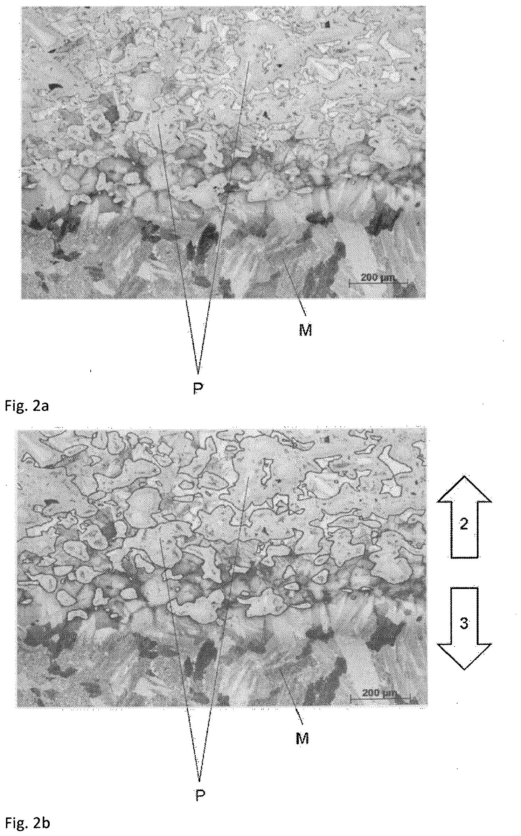

Figur 2a und Figur 2b zeigen jeweils einen metallografischen Schliff der Fügezone 4 einer erfindungsgemäßen Beschichtungsquelle 1 mit einer Korngrenzenätzung am Beispiel eines TiSi 70/30at% Werkstoffes auf einer Titan-Stabilisierungsschicht 3. Bei einer Korngrenzenätzung werden die Korngrenzen sichtbar gemacht. Man erkennt hier also die Form und die Orientierung einzelner Körner. Man beachte die von Figur 1 verschiedene Größenskala, erkennbar am Größenbalken.

Die Abbildungen in Figur 2a und 2 b unterscheiden sich darin, dass in Figur 2b die Korngrenzen der TiSi-Körner, welche der weiteren Phase P entsprechen, zur besseren Unterscheidbarkeit mit einer fetten schwarzen Linie nachgezogen wurden. Ansonsten entspricht Figur 2 b der Figur 2a.

Die Orientierung des metallografischen Schliffes wird durch die Pfeile am rechten Rand des Blattes klargestellt. Der Pfeil mit Bezugszeichen 2 weist in die Richtung, in welche sich die Targetschicht 2 erstreckt. Der Pfeil mit Bezugszeichen 3 weist in die Richtung, in welche sich die Stabilisierungsschicht 3 erstreckt.

Die einzelnen TiSi-Körner (Phase P) sind in die metallische Phase M eingebettet. Es sei bemerkt, dass die Linien der Bezugszeichen beispielhaft auf einzelne Körner der Phase P bzw. der metallischen Phase M gerichtet sind. Natürlich besteht die

Phase P bzw. die metallischen Phase M aus einer Vielzahl von Körnern. Im vorliegenden Werkstoffsystem sind die eher rundlichen Körner der Phase P hinsichtlich ihrer Gestalt gut von den kantigen Körnern der metallischen Phase M zu unterscheiden.

Erkennbar ist, dass das Gefüge der Stabilisierungsschicht 3 kontinuierlich in die metallische Phase M der Targetschicht 2 übergeht. Die einzelnen Ti-Körner in der Stabilisierungsschicht 3 als auch in der metallischen Phase M der Targetschicht 2 sind an der charakteristischen Zwillingsbildung im Korninneren zu erkennen. In der Fügezone ist eine zunehmende Konzentration von Partikeln der weiteren Phase P (hier die TiSi-Körner) ausgehend von dem Material der Stabilisierungsschicht 3 in einer Richtung zur Targetschicht 2 zu erkennen.

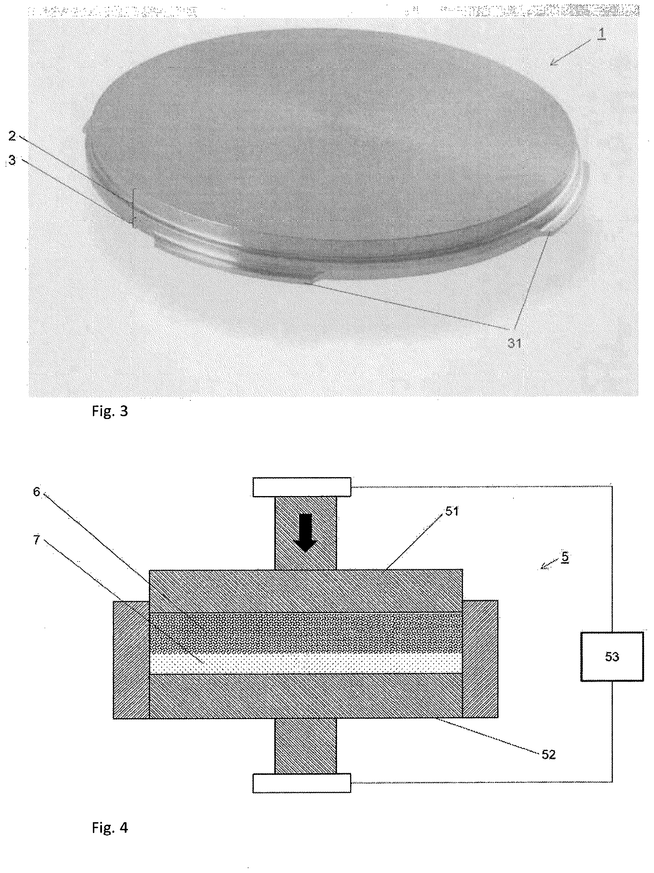

Figur 3 zeigt eine erfindungsgemäße Beschichtungsquelle 1 in einer perspektivischen Ansicht. Im gezeigten Ausführungsbeispiel ist die Stabilisierungsschicht 3 gegenüber der Targetschicht 2 optisch zu unterscheiden. Die Stufe am Umfang in der Beschichtungsquelle 1 entspricht hier also nicht dem Übergang von Targetschicht 2 in die Stabilisierungsschicht 3. Zu sehen sind Bajonetthalterungen 31 an der Stabilisierungsschicht 3, welche ein Positionieren der Beschichtungsquelle 1 in einer Beschichtungsanlage erleichtern.

Figur 4 zeigt schematisch ein Presswerkzeug 5 zur Herstellung eines Rohlings für eine Beschichtungsquelle 1 nach dem erfindungsgemäßen Verfahren. Das Presswerkzeug 5 weist einen Ober- und einen Unterstempel (51, 52) und eine Heizeinrichtung 53 auf.

Im Presswerkzeug 5 eingeschichtet sind eine erste Pulvermischung 6, die in ihrer Zusammensetzung der Targetschicht 2 entspricht und eine zweite Pulvermischung 7, die in ihrer Zusammensetzung der mechanischen Stabilisierungsschicht 3 entspricht. Die Verdichtung erfolgt wie durch den Pfeil angedeutet axial.

### Liste der verwendeten Bezugszeichen:

- 1: Beschichtungsquelle
- 2: Targetschicht
- 3: Stabilisierungsschicht
- 31: Bajonetthalterung
- 4: Fügezone
- 5: Presswerkzeug
- 51: Oberstempel
- 52: Unterstempel
- 53: Heizeinrichtung
- 6: erste Pulvermischung
- 7: zweite Pulvermischung
- M: Metallische Phase
- P: weitere Phase

## Patentansprüche

1. Verfahren zur Herstellung einer Beschichtungsquelle (1) zur physikalischen Gasphasenabscheidung, die Beschichtungsquelle (1) wenigstens umfassend
- eine Targetschicht (2) bestehend aus einem wenigstens zweiphasigen Verbundwerkstoff, der eine metallische Phase (M) und wenigstens eine weitere Phase (P) enthält,
- eine mechanische Stabilisierungsschicht (3), welche an einer Seite der Targetschicht (2) mit der Targetschicht (2) verbunden ist,
**dadurch gekennzeichnet, dass** eine erste Pulvermischung (6), die in ihrer Zusammensetzung dem wenigstens zweiphasigen Verbundwerkstoff entspricht und eine zweite Pulvermischung (7), die in ihrer Zusammensetzung der mechanischen Stabilisierungsschicht (3) entspricht, in übereinander angeordneten Schichten heißgepresst werden, indem die Pulver in einem Presswerkzeug bei solchen Temperaturen axial verdichtet werden, dass ein Sintern der Pulver zu einem Festkörper erfolgt.

2. Verfahren nach Anspruch 1, wobei die übereinander angeordneten Schichten während des Verdichtens mit einem elektrischen Strom beaufschlagt und/oder induktiv geheizt werden.

3. Verfahren nach wenigstens einem der vorangehenden Ansprüche, wobei die erste und/oder zweite Pulvermischung (6, 7) in Form eines nur vorverdichteten Vorpresslings verwendet wird, wobei die Endverdichtung und Verbindung durch das heiße Verdichten erfolgt.

4. Verfahren nach wenigstens einem der vorangehenden Ansprüche, wobei als metallische Phase (M) des wenigstens zweiphasigen Verbundwerkstoffes Titan oder eine Titan-Legierung verwendet wird.

5. Verfahren nach wenigstens einem der vorangehenden Ansprüche, wobei der Werkstoff für die metallische Phase (M) des wenigstens zweiphasigen Verbundwerkstoffes und der Werkstoff der mechanischen Stabilisierungsschicht zu mindestens 80 at.-% aus dem gleichen Metall bestehen.

6. Verfahren nach wenigstens einem der vorangehenden Ansprüche, wobei die weitere Phase (P) mit einem Anteil von mehr als 25 Volumenprozent in Bezug auf den wenigstens zweiphasigen Verbundwerkstoff verwendet wird.

7. Verfahren nach wenigstens einem der vorangehenden Ansprüche, wobei als weitere Phase (P) ein von Titan verschiedenes Element und/oder eine Titan-Verbindung verwendet wird.

8. Verfahren nach wenigstens einem der vorangehenden Ansprüche, wobei die erste und die zweite Pulvermischung (6, 7) ganzflächig aneinander angrenzend übereinander angeordnet werden.

9. Beschichtungsquelle (1) zur physikalischen Gasphasenabscheidung, mit:
- einer Targetschicht (2) bestehend aus einem wenigstens zweiphasigen Verbundwerkstoff, der eine metallische Phase (M) und wenigstens eine weitere Phase (P) enthält, wobei die metallische Phase (M) und alle weiteren vorhandenen Phasen Schmelzpunkte größer als 1000 °C aufweisen,
- einer mechanischen Stabilisierungsschicht (3), welche an einer Seite der Targetschicht (2) mit der Targetschicht (2) verbunden ist,
**dadurch gekennzeichnet, dass** die Targetschicht (2) und die mechanische Stabilisierungsschicht (3) durch eine Fügezone (4) miteinander verbunden sind, welche ausgehend von der mechanischen Stabilisierungsschicht (3) in einer Richtung zur Targetschicht (2) hin ohne Ausbildung einer Grenzfläche eine zunehmende Konzentration von Partikeln der weiteren Phase (P) des wenigstens zweiphasigen Verbundwerkstoffes aufweist.

10. Beschichtungsquelle (1) nach Anspruch 9, wobei die metallische Phase (M) des wenigstens zweiphasigen Verbundwerkstoffes Titan oder eine Titan Legierung aufweist.

11. Beschichtungsquelle (1) nach Anspruch 9 oder 10, wobei der Werkstoff für die metallische Phase (M) des wenigstens zweiphasigen Verbundwerkstoffes und der Werkstoff der mechanischen Stabilisierungsschicht (3) zu mindestens 80 at.-% aus dem gleichen Metall bestehen.

12. Beschichtungsquelle (1) nach wenigstens einem der Ansprüche 9 bis 11, wobei die weitere Phase (P) einen Anteil von mehr als 25 Volumenprozent in Bezug auf den wenigstens zweiphasigen Verbundwerkstoff aufweist.

13. Beschichtungsquelle (1) nach wenigstens einem der Ansprüche 9 bis 12, wobei die weitere Phase (P) aus einem von Titan verschiedenen Element und/oder einer Titan-Verbindung besteht.

14. Beschichtungsquelle (1) nach wenigstens einem der Ansprüche 9 bis 13, wobei die mechanische Stabilisierungsschicht (3) aus dem gleichen metallischen Material besteht, welches die metallische Phase (M) der Targetschicht (2) bildet, und zumindest im Wesentlichen frei von Partikeln der weiteren Phase (P) des wenigstens zweiphasigen Verbundwerkstoffes ist.

15. Beschichtungsquelle (1) nach wenigstens einem der Ansprüche 9 bis 13, wobei die mechanische Stabilisierungsschicht (3) ihrerseits aus einem wenigstens zweiphasigen Verbundwerkstoff besteht.

## Claims

1. Process for producing a coating source (1) for physical vapour deposition, where the coating source (1) comprises at least
- a target layer (2) consisting of an at least two-phase composite which contains a metallic phase (M) and at least one further phase (P),
- a mechanical stabilizing layer (3) which is joined to the target layer (2) on one side of the target layer (2),
**characterized in that** a first powder mixture (6) which corresponds in terms of its composition to the at least two-phase composite and a second powder mixture (7) which corresponds in terms of its composition to the mechanical stabilizing layer (3) are hot pressed in superposed layers by axially compressing the powders in a pressing tool at temperatures which are such that sintering of the powder to form a solid body occurs.

2. Process according to Claim 1, wherein the superposed layers are supplied with an electric current and/or inductively heated during densification.

3. Process according to at least one of the preceding claims, wherein the first and/or second powder mixture (6, 7) is used in the form of an only predensified intermediate compact and final densification and joining are effected by the hot densification.

4. Process according to at least one of the preceding claims, wherein titanium or a titanium alloy is used as metallic phase (M) of the at least two-phase composite.

5. Process according to at least one of the preceding claims, wherein the material for the metallic phase (M) of the at least two-phase composite and the material of the mechanical stabilizing layer consist to an extent of at least 80 at.% of the same metal.

6. Process according to at least one of the preceding claims, wherein the further phase (P) is used in a proportion of more than 25 percent by volume based on the at least two-phase composite.

7. Process according to at least one of the preceding claims, wherein an element other than titanium and/or a titanium compound is used as further phase (P).

8. Process according to at least one of the preceding claims, wherein the first and second powder mixtures (6, 7) are arranged above one another with their full areas adjoining one another.

9. Coating source (1) for physical vapour deposition, comprising:
- a target layer (2) consisting of an at least two-phase composite which contains a metallic phase (M) and at least one further phase (P), where the metallic phase (M) and all further phases present have melting points above 1000°C,
- a mechanical stabilizing layer (3) which is joined to the target layer (2) on one side of the target layer (2),
**characterized in that** the target layer (2) and the mechanical stabilizing layer (3) are joined to one another via a joining zone (4) which has an increasing concentration of particles of the further phase (P) of the at least two-phase composite going from the mechanical stabilizing layer (3) in the direction of the target layer (2) without formation of an interface.

10. Coating source (1) according to Claim 9, wherein the metallic phase (M) of the at least two-phase composite comprises titanium or a titanium alloy.

11. Coating source (1) according to Claim 9 or 10, wherein the material for the metallic phase (M) of the at least two-phase composite and the material of the mechanical stabilizing layer (3) consist to an extent of at least 80 at.% of the same metal.

12. Coating source (1) according to at least one of Claims 9 to 11, wherein the further phase (P) is present in a proportion of more than 25 percent by volume based on the at least two-phase composite.

13. Coating source (1) according to at least one of Claims 9 to 12, wherein the further phase (P) consists of an element other than titanium and/or a titanium compound.

14. Coating source (1) according to at least one of Claims 9 to 13, wherein the mechanical stabilizing layer (3) consists of the same metallic material which forms the metallic phase (M) of the target layer (2) and is at least essentially free of particles of the further phase (P) of the at least two-phase composite.

15. Coating source (1) according to at least one of Claims 9 to 13, wherein the mechanical stabilizing layer (3) itself consists of an at least two-phase composite.

## Revendications

1. Procédé de production d'une source de revêtement (1) destinée au dépôt physique en phase gazeuse, la source de revêtement (1) comprenant au moins
- une couche cible (2) comprenant un matériau composite formé d'au moins deux phases et contenant une phase métallique (M) et au moins une autre phase (P),
- une couche de stabilisation mécanique (3) qui est reliée à la couche cible (2) sur un côté de la couche cible (2),
**caractérisé en ce qu'**un premier mélange pulvérulent (6), dont la composition correspond au matériau composite formé d'au moins deux phases, et un deuxième mélange pulvérulent (7), dont la composition correspond à la couche de stabilisation mécanique (3), sont pressés à chaud en couches superposées par compression axiale des poudres dans un outil de pressage à des températures permettant de fritter la poudre pour former un corps solide.

2. Procédé selon la revendication 1, les couches disposées les unes au-dessus des autres étant soumises à un courant électrique et/ou chauffées par induction lors de la compression.

3. Procédé selon l'une au moins des revendications précédentes, le premier et/ou deuxième mélange pulvérulent (6, 7) étant utilisés sous la forme d'une ébauche de préformage pré-compressée, la compression finale et la liaison étant effectuées par la compression à chaud.

4. Procédé selon l'une au moins des revendications précédentes, du titane ou un alliage de titane étant utilisé comme phase métallique (M) du matériau composite formé d'au moins deux phases.

5. Procédé selon l'une au moins des revendications précédentes, le matériau de la phase métallique (M) du matériau composite formé d'au moins deux phases et le matériau de la couche de stabilisation mécanique comprenant au moins 80 % atomique du même métal.

6. Procédé selon l'une au moins des revendications précédentes, l'autre phase (P) étant utilisée dans une proportion de plus de 25 % en volume par rapport au matériau composite formé d'au moins deux phases.

7. Procédé selon l'une au moins des revendications précédentes, un élément autre que le titane et/ou un composé du titane étant utilisé comme autre phase (P).

8. Procédé selon l'une au moins des revendications précédentes, le premier et le deuxième mélange pulvérulent (6, 7) étant disposés l'un au-dessus de l'autre de manière adjacente l'un de l'autre sur toute la surface.

9. Source de revêtement par dépôt physique en phase gazeuse (1) comprenant :
- une couche cible (2) comprenant un matériau composite formé d'au moins deux phases contenant une phase métallique (M) et au moins une autre phase (P), la phase métallique (M) et toutes les autres phases présentes ayant des points de fusion supérieurs à 1000 °C,
- une couche de stabilisation mécanique (3) qui est reliée à la couche cible (2) sur un côté de la couche cible (2),
**caractérisé en ce que** la couche cible (2) et la couche de stabilisation mécanique (3) sont reliées l'une à l'autre par une zone de jonction (4) qui présente, à partir de la couche de stabilisation mécanique (3), une concentration croissante de particules de l'autre phase (P) du matériau composite formé d'au moins deux phases en direction de la couche cible (2) sans former d'interface.

10. Source de revêtement (1) selon la revendication 9, la phase métallique (M) du matériau composite formé d'au moins deux phases comprenant du titane ou un alliage de titane.

11. Source de revêtement (1) selon la revendication 9 ou 10, le matériau de la phase métallique (M) du matériau composite formé d'au moins deux phases et le matériau de la couche de stabilisation mécanique (3) comprenant au moins 80 % atomique du même métal.

12. Source de revêtement (1) selon l'une au moins des revendications 9 à 11, l'autre phase (P) comportant une proportion de plus de 25 % en volume par rapport au matériau composite formé d'au moins deux phases.

13. Source de revêtement (1) selon l'une au moins des revendications 9 à 12, l'autre phase (P) comprenant un élément autre que le titane et/ou un composé du titane.

14. Source de revêtement (1) selon l'une au moins des revendications 9 à 13, la couche de stabilisation mécanique (3) comprenant le même matériau métallique qui forme la phase métallique (M) de la couche cible (2) et étant au moins sensiblement exempte de particules de l'autre phase (P) du matériau composite formé d'au moins deux phases.

15. Source de revêtement (1) selon l'une au moins des revendications 9 à 13, la couche de stabilisation mécanique (3) comprenant elle-même un matériau composite formé d'au moins deux phases.
